# EUROPÄISCHE PATENTANMELDUNG

(11) **EP 1 138 803 A2**
(43) Veröffentlichungstag der Anmeldung: **04.10.2001**
(21) Anmeldenummer: 01107283.2
(22) Anmeldetag: 23.03.2001
(51) Int. Cl.: C23C 18/30, H05K 3/10

(54) **Verfahren zur Metallisierung eines Isolators und/oder eines Dielektrikums**

(30) Priorität: 27.03.2000 DE 10015214
(71) Anmelder: Infineon Technologies AG, 81669 München (DE)
(72) Erfinder: Lowack, Klaus, Dr., 91054 Erlangen (DE); Schmid, Guenter, Dr., 91334 Hemhofen (DE); Sezi, Recai, Dr., 91341 Roettenbach (DE)
(74) Vertreter: Viering, Hans-Martin, Dipl.-Ing.

(57) **Zusammenfassung**

Die Erfindung betrifft ein Verfahren zur Metallisierung eines Isolators und/oder Dielektrikums, wobei der Isolator zunächst aktiviert, anschließend mit einem weiteren Isolator beschichtet und dieser strukturiert, dann der erste bekeimt und schließlich metallisiert wird.

## Beschreibung

Die Erfindung betrifft ein Verfahren zur Metallisierung eines Isolators und/oder Dielektrikums.

Die Metallschicht auf einem Isolator, wie beispielsweise der Isolierschicht eines elektronischen oder mikroelektronischen Bauelements, wird derzeit so aufgebracht, dass zuerst auf den Isolator mittels eines Vakuumprozesses eine dünne Metallschicht aufgebracht wird. Nach der Abdeckung mit Photolack und dessen Strukturierung wird die Metallschicht chemisch oder elektrochemisch verstärkt, anschließend der Lack gestrippt und die erste dünne Metallschicht zurückgeätzt. Dieses Verfahren ist komplex und teuer. Ausserdem kann das Strippen des Lacks zur Partikelbildung und demzufolge zu einer Ausbeuteverringerung führen.

Aus der DE 198 51 101 A1 ist ein Verfahren zur selektiven Abscheidung einer Metallschicht auf der Oberfläche eines Kunststoffsubstrats bekannt. Dabei werden die zu beschichteten bereiche der Oberfläche mit elektromagnetischer Strahlung beaufschlagt, wobei chemische Bindungen gespalten und funktionelle Gruppen als reaktive Zentren geschaffen werden. Die Bestrahlung erfolgt insbesondere mit UV-Strahlung bei einer Wellenlänge < 320 nm, vorzugsweise 222 nm. Nach der Bestrahlung, die unter Zuhilfenahme einer Maske oder mittels eines schreibenden Laserstrahls erfolgt, wird an den reaktiven funktionellen Gruppen der Oberfläche eine Edelmetallverbindung fixiert. Dazu wird das Kunststoffteil entweder noch in eine Quell-Lösung getaucht, beispielsweise in eine 5-molare wässrige NaOH-Lösung, oder unmittelbar mit einer die abzuscheidende Substanz enthaltenden Lösung, d.h. mit einer Keimlösung, kontaktiert. Nachfolgend wird in einem stromlosen Metallisierungsbad die Metallschicht abgeschieden.

Eine derartige Vorgehensweise ist in der Mikroelektronik nicht praktizierbar, da für die Spaltung der chemischen Bindungen energiereiche Strahlung, insbesondere der Wellenlänge von 222 nm, erforderlich ist. Es gibt aber keine ausreichend leistungsstarken Lampen dieser Wellenlänge, so dass die Belichtungszeiten deutlich höher liegen (Faktor > 10) als bei Standardbelichtungen. Dadurch wird aber der Durchsatz an bekeimbaren Substraten stark eingeschränkt und zudem sind die benötigten Excimer-UV-Lampen sehr teuer. Ausserdem werden bei der Spaltung der Bindungen niedermolekulare Bruchstücke freigesetzt, welche die teuren Masken verschmutzen können. Ein Nachteil des bekannten Verfahrens ist ferner, dass es nur positiv arbeitet, d.h. nur die belichteten Bereiche können bekeimt werden. Eine Arbeitsweise im negativen Modus, wobei die nicht-belichteten Bereiche bekeimt werden, ist dagegen nicht möglich. Dies kann dann hohe Zusatzkosten für neue Masken bedeuten, wenn beispielsweise für bereits existierende Prozesse nur Negativmasken vorhanden sind.

Zur Metallisierung dielektrischer Schichten auf einem elektronischen Bauelement ist ein Verfahren aus der DE 199 57 130.9 (noch unveröffentlicht) bekannt, bei dem ein photoempfindliches Dielektrikum auf ein Substrat aufgebracht wird, das Dielektrikum in einem anschließenden Arbeitsschritt belichtet und entweder mit oder ohne Wärmebehandlung bekeimt und metallisiert wird. Nachteilig an diesem Verfahren ist, dass es auf photosensitive Dielektrika beschränkt ist.

Aufgabe der Erfindung ist es, ein Verfahren zur Metallisierung von Isolatoren zu schaffen, das kompatibel mit den Gegebenheiten bestehender Prozesslinien ist, im positiven und negativen Modus arbeitet und nicht auf photosensitive Dielektrika beschränkt ist.

Lösung der Aufgabe und Gegenstand der Erfindung ist ein Verfahren zur Metallisierung zumindest einer Isolierschicht eines elektronischen oder mikroelektronischen Bauteils, deren Schichtdicke maximal 50 µm beträgt, wobei zunächst
- zumindest eine Isolierschicht auf das Substrat aufgebracht und durch Behandlung mit einem Aktivator aktiviert wird,
- dann eine weitere Isolierschicht aufgebracht und strukturiert wird und schließlich
- die erste Isolierschicht bekeimt und metallisiert wird.

Dem Verfahren nach der Erfindung können alle Isolierschichten eines elektronischen oder mikroelektronischen Bauteils unterworfen werden, vorausgesetzt, sie lassen sich durch geeignete Aktivatoren so aktivieren, dass eine Bekeimung möglich ist.

Nach einer Ausführungsform werden 5 Schichten auf ein Substrat aufgebracht und jeweils strukturiert. Dieser Aufbau wird dann aktiviert, bevor die oberste Isolierschicht aufgebracht und strukturiert wird. Danach wird die freiliegende Oberfläche der aktivierten unteren Schichten bekeimt und metallisiert.

Durch das vorliegende Verfahren lassen sich z.B. benachbarte Isolierschichten selektiv metallisieren, indem z.B. die untere Schicht zuerst aktiviert und dann die obere Schicht aufgetragen wird. Vor der Metallisierung wird die obere Schicht strukturiert, so dass die untere Schicht an den Stellen, an denen Metallisierung stattfinden soll, freiliegt. Bei der Bekeimung und Metallisierung wird dann nur die untere und aktivierte Schicht metallisiert.

Unter dem Begriff "Isolierschicht oder Isolationsschicht" versteht man hier ein elektrisch isolierendes Material, das nach der Fertigstellung des Bauelements in diesem Bauelement verbleibt, d.h. nicht entfernt wird. Materialien, die als Strukturierungshilfsmittel dienen und nach der Durchführung eines Prozesses (z.B. Metallisierung, Ätzung) wieder entfernt werden, wie z.B. kommerzielle Photolacke auf Novolak-Basis, sind darunter nicht zu verstehen. Ebenso sind Materialien, die ein Bestandteil des Substrates sind (z.B. Leiterplatten auf Epoxidharzbasis) oder als Abdeckung verwendet werden (z.B. Passivierungsschicht auf einem IC aus Siliziumoxid und/oder -nitrid oder IC-Gehäuse aus gefülltem Epoxidharz, d.h. Pressmasse, "mold compound"), keine "Isolierschichten" im Sinne des hier gebrauchten Begriffs.

Die Dicke der Isolierschicht ist vorzugsweise zwischen 0,05 und 50 µm, besonders bevorzugt zwischen 0,1 und 20 µm.

Die Isolierschicht besteht bevorzugt aus einem Polymer. Das Polymer weist vorteilhaft eine hohe chemische und thermische Beständigkeit auf. Hierdurch werden Löt- und Reinigungsprozesse sowie die Aktivierung (chemisch und/oder physikalisch) unbeschadet überstanden. Vorteilhaft hat sich insbesondere der Einsatz folgender Arten von Polymeren erwiesen: Dielektrika wie Polyimide, Polybenzoxazole, Polybenzimidazole; vorwiegend aromatische Polyether, Polyetherketone, Polyethersulfone; Benzocyclobuten, aromatische Kohlenwasserstoffe Polychinoline, Polychinoxaline, Polysiloxane (Silicone), Polyurethane oder Epoxidharze. Copolymere oder Mischungen dieser Polymeren untereinander sind ebenfalls geeignet. Weiterhin eignen sich Verbindungen bzw. Polymere mit organisch-anorganischer Struktur, wie z.B. Organosilizium-Organophosphor oder Organoborverbindungen. Bekanntlich kann man alle der genannten Materialklassen entweder in fertiger Form applizieren (Schleudern, Siebdruck etc.) oder aus der Gasphase auf dem Substrat oder der ersten Isolierschicht eine Vorstufe abscheiden und dort das Polymer erzeugen. Zu den Schichten, die auf dem Substrat oder einer Isolierschicht erzeugt werden, gehören z.B. Schichten aus Kohlenstoff, a-C:H sowie a-C:H-Schichten (amorph) mit weiteren Elementen wie Si, P, O, B. Rein anorganische Materialien wie Siliziumoxid und -nitrid zählen nur dann dazu, wenn sie - als die obere der beiden Schichten, z.B. über eine Lochmaske, Drucktechnik und/oder Lithographie aufgebracht und strukturiert werden.

Prinzipiell sind alle Materialien geeignet, die bei den durchzuführenden Prozessen stabil sind, elektrisch gut isolierend wirken und auf dem fertigen Bauelement keinen Störeffekt haben. Besonders geeignet sind photosensitive Formulierungen der Isoliermaterialien.

Die Isolierschicht kann auch mehrere der oben genannten Komponenten sowie Füllstoff enthalten. Besonders für die Verwendung als Paste, aber auch für Siebdrucke, können dem Isoliermaterial und/oder Dielektrikum geeignete Füllstoffe beigemischt werden. Es kann beispielsweise in gelöster Form oder als Paste auf das Substrat aufgetragen werden. Geeignete Techniken sind z.B. Schleudern, Gießen, Dispensen, Rakeln, Tampondruck, Tintenstrahldruck und/oder Siebdruck.

Eine erste Isolierschicht wird beispielsweise mittels Schleudertechnik auf das Substrat oder eine andere Isolierschicht aufgetragen, je nach Bedarf getrocknet und/oder ausgeheizt, wenn dies zur Erhaltung der Endeigenschaften notwendig ist. Anschliessend wird sie mit einem Aktivator aktiviert. Danach wird eine zweite Isolationsschicht auf die erste aufgebracht und getrocknet. Die zweite (obere) Isolierschicht wird z.B. für die Strukturierung durch eine Maske belichtet, entwickelt und getrocknet und/oder ausgeheizt.

Vor der Aktivierung kann die erste Isolierschicht ggf. ebenfalls strukturiert werden.

Die Aktivierung kann durch Eintauchen, Ätzen, Aussetzen, Bestrahlen, Besputtern, Erhitzen, Anlösen, Benetzen oder eine andere bekannte Technik erfolgen.

Der Aktivator ist je nach Ausführungsform ein Gas (oder eine Gasmischung), eine Flüssigkeit, eine Lösung oder ein Plasma. Der Aktivator kann insbesondere auch eine Kombination von einem Gas mit einer Flüssigkeit oder eine sonstige Kombination mehrerer Aktivatoren sein. Die Aktivierung modifiziert selektiv eine Isolierschicht oder die Oberfläche einer Isolierschicht beispielsweise in der Weise, dass später nur diese Schicht bekeimt und/oder metallisiert werden kann. Eine andere Aktivierung wie eine für eine spätere Photosensibilisierung geeignete und andere Aktivierungen sind auch von der Erfindung mitumfasst.

Flüssige Aktivatoren sind z.B. basische Reagenzien wie Lösungen eines oder mehrerer Alkali- und/oder Erdalkalihydroxiden, Ammoniumhydroxiden; oxidierende Reagenzien wie die Lösung von Wasserstoffperoxid, Chromat, Permanganat, (Per)Chlorat und/ oder Peroxosulfat; Lösungen, die eine Säure wie Schwefel-, Salz-, Salpeter- und/oder Phosphorsäure enthalten. Die genannten Lösungen können alle einzeln oder auch in beliebiger Kombination zum Einsatz kommen.

### Aktivatoren, die als Plasma vorliegen sind z.B.:

Sauerstoff-, Chlor-, Kohlendioxid-, Schwefeldioxid-, Edelgas- und/oder Ammoniakplasmen; als Gase eignen sich z.B. Ozon, Sauerstoff, Halogene und/oder Schwefeldioxid sowie deren Mischungen.

Das Substrat ist bevorzugt ein Halbleiter (Silizium (Si), Galliumarsenid, Germanium (Ge)) oder Keramik, wobei es unterhalb der ersten Isolierschicht schon elektronische Schaltungen incl. Metall- und Isolierschichten geben kann (z.B. ein front-end bearbeitetes Substrat). Das Substrat kann aber auch Glas, Leiterplatte und/oder Metall sein. Das Substrat kann ausserdem auch eines der oben genannten Materialien mit einer aufgebrachten Isolierschicht sein.

Die Keimlösung ist die Lösung oder Emulsion eines Metalls (oder einer Metallverbindung) in ionogener oder kolloidaler Form. Diese Lösung kann neutral, basisch oder sauer sein. Bevorzugte Keimlösungen sind alle Lösungen von Metallen und Nichtmetallen bzw. deren Verbindungen, die die Abscheidung eines Metalls aus einer redoxchemisch metastabilen Lösung dieses Metalls katalysieren. Zur Herstellung der Keimlösung werden bevorzugt Edelmetalle (Ruthenium (Ru), Rhodium (Rh), Palladium (Pd), Osmium (Os), Iridium (Ir), Platin (Pt), Silber (Ag), Gold (Au)) bzw. deren Verbindungen und Komplexe (organisch und/oder anorganisch) eingesetzt. Palladiumverbindungen wie Palladiumacetat und Palladiumchlorid werden bereits zur Metallisierung verwendet.

Als Komplexe sind sowohl die klassischen cis-Diaminodi(pseudo)halogeno- oder alkenyl-Komplexe des Pt(II) oder Pd(II) geeignet, da sie zur Reaktion geeignete Gruppen enthalten. Trisphosphinokomplexe des Pd und Pt enthalten das Metall bereits in der Oxidationsstufe 0, wodurch die Bildung von Keimen bzw. Clustern erheblich vereinfacht und an modifizierten Oberflächen favorisiert wird. Die Ligandensysteme lassen sich sehr leicht modifizieren (Sulfonierung, Aminierung, z.B. 3-[Bis(3-sulfophenyl)phosphino]benzenesulfonic acid; 1,3,5-Triaza-7-phosphatricyclo[3,3,1,1]decane), so dass auch angepasst geladene Spezies erhalten werden können. Die Komplexe werden einfach durch Zumischen des Liganden zu einer Salzlösung des Metalls/der Metalle erhalten.

Als Lösungsmittel kommen Wasser und organische Lösungsmittel sowie Mischungen in Frage. Besonders geeignet sind Isopropanol, Ethanol, γ-Butyrolacton, Butanon, N-Methylpyrrolidon, Aceton, Cyclohexanon, Cyclopentanon, Tetrahydrofuran, Ethoxyethylpropionat, Ethoxyethylacetat, Essigsäureethylester oder Essigsäurebutylester. Die Lösung kann auch Tenside (ionische und/oder nicht ionische Tenside) oder Amine (z.B. Triethylamin oder Tetramethylammoniumhydroxid) enthalten.

Das Verfahren ist insbesondere deswegen so vorteilhaft, weil viele elektronische und/oder mikroelektronische Bauelementevor ihrer Bearbeitung mit mindestens zwei Isolierschichtenmit einem Buffercoating beschichtet sind (in dieser Form kommen z.B. Wafer vom Front-End-Bereich; das Buffercoating ist beispielsweise Polyimid oder Polybenzoxazol; darunter befinden sich beispielsweise die anorganischen Passivierungsschichten Siliziumnitrid und/oder -oxid). Dieses Buffercoating kann bereits eine Isolierschicht im Sinne der Erfindung sein, d.h. sie kann aktiviert und anschliessend mit einer weiteren Isolierschicht beschichtet werden. Die obere Schicht wird entsprechend einer Ausführungsform des Verfahrens strukturiert, wobei dann in den freigelegten Bereichen die aktivierte untere Schicht bekeimt und metallisiert werden kann.

Anhand von Ausführungsbeispielen soll die Erfindung noch näher erläutert werden.

### Beispiel 1

Ein handelsüblicher Wafer mit einer bereits cyclisierten Polyimidbeschichtung wird wie folgt umverdrahtet: Das Polyimid wird durch einen kurzen Atzschritt 25 s im Sauerstoffplasma aktiviert (500 W, 50 sccm Sauerstoff, 50 mTorr). Der aktivierte Wafer wird 10 s in deionisiertes Wasser getaucht, das Wasser abgeschleudert und der Wafer 60 s bei 120°C getrocknet. Anschließend wird eine zweite Lage eines photosensitiven Polyimids aufgeschleudert strukturiert und in einem Ofen bei 400°C unter Stickstoff ausgehärtet. Bei der Plasma-Aktivierung der 1. Schicht entsteht die aktivierte Oberfläche, auf der sich durch Eintauchen in eine Lösung von 200 mg η²-Bipyridylη²4,4'-Diaminostilbenopal-ladium(II) in 500 ml Isopropanol selektiv der Palladiumkomplex anbinden lässt (Bekeimung). Anschließend wird der Palladiumkomplex durch Tauchen in eine alkalische Borhydrid-Lösung (1 g Natriumborhydrid, 5 g Natriumhydroxid gelöst in 1000 ml Wasser) reduziert (RT, 2 min). Daraufhin erfolgt die chemische Verkupferung durch Tauchen (10 min) in ein warmes handelsübliches Kupferbad.

### Beispiel 2

Die Bekeimung erfolgt analog Beispiel 1, jedoch wird hier der selektiv angekoppelte Palladiumkomplex photochemisch unter Bildung eines Cyclobutanderivates (C₄(C₆H₄NH₂)₄H₄) und Palladium(0) reduziert. Für diese Flutbelichtung (Belichtung ohne Maske mit einer Belichtungsenergie von 300 mJ/cm²) wird eine polychromatische Energiequelle mit Emissionen im Bereich von 200-500 nm verwendet, z.B. eine Quecksilberhochdrucklampe.

### Beispiel 3

Beim Verfahren analog Beispiel 1 wird anstelle des Palladium(II)-Komplexes der entsprechende Platin(II)-Komplex eingesetzt. Das Ergebnis ist analog.

### Beispiel 4

Beim Verfahren analog Beispiel 1 wird anstelle des Palladium(II)-Komplexes der Di-u-chloro-tetraethylendirhodium(I)-Komplex verwendet. Das Ergebnis ist analog.

### Beispiel 5

Ein photosensitives Polyimid wird nach Herstellerangaben auf ein Siliziumsubstrat geschleudert, belichtet, entwickelt und ausgehärtet. Für die Aktivierung des Polyimids wird das Substrat anschließend in folgende Lösungen getaucht:
- 10 min in eine 40°C warme alkalische Permanganat-Lösung, bestehend aus 140 g/l Natriumpermanganat und 50 g/l Natriumhydroxid
- Spülen in deionisiertem Wasser
- Eintauchen für 3 min bei Raumtemperatur in halbkonzentrierte Schwefelsäure (5 mol/l)
- Spülen in deionisiertem Wasser.
Danach wird eine zweite Lage Polyimid aufgeschleudert, wie oben beschrieben strukturiert und ausgehärtet. Die freigelegten Stellen der ersten, aktivierten Polyimidschicht werden durch Eintauchen des Substrats für 45 min in eine 45°C warme, käufliche ionogene Palladium-Lösung bekeimt. Nach Spülen mit deionisiertem Wasser (Tauchen 3 s) erfolgt eine Reduktion des ionogenen Palladiums durch eine alkalische Borhydrid-Lösung, bestehend aus 1g Natriumborhydrid und 5 g Natriumhydroxid pro 1 l deionisiertem Wasser. Nach erneutem Spülen mit deionisiertem Wasser und Trocknen im Stickstoffstrom erfolgt die chemische Metallisierung durch 15 min Eintauchen in ein handelsübliches Nickelbad.

### Beispiel 6

Anstelle des Nickelbades wird ein handelsübliches Kupferbad verwendet. Sonst wie Beispiel 5.

### Beispiel 7

Auf einen Siliziumwafer wird das Dielektrikum Polybenzoxazol durch Schleudertechnik aufgebracht, bei 100°C vorgetrocknet und auf einer Hotplate jeweils 1 min bei 200°C, 260°C und 350°C unter Stickstoff ausgehärtet. Anschließend wird die Oberfläche in einem Wassergasplasma (CO:H₂ wie 1:1; 500 Watt, 50sccm, 50 mTorr) aktiviert. Die aktivierte Oberfläche wird 10 s in deionisiertes Wasser getaucht, das Wasser abgeschleudert und der Wafer 60s bei 120°C getrocknet. Danach wird eine zweite Lage Polybenzoxazol durch Siebdruck aufgebracht, vorgetrocknet und - wie oben- ausgehärtet. Bei der Plasma-Aktivierung entsteht eine carboxylgruppenhaltige Oberfläche, auf der sich durch Eintauchen in eine Lösung von 200 mg η²-Bipyridyl-η²4,4'-Diamino-stilbenopalladium(II) in 500 ml Isopropanol selektiv der Palladiumkomplex anbinden lässt. Anschließend wird der Palladiumkomplex in einer alkalischen Borhydrid-Lösung (1g Natriumborhydrid, 5 g Natriumhydroxid gelöst in 1000 ml Wasser) reduziert (RT, 2 min). Daraufhin erfolgt die chemische Verkupferung (10 min) mit einem handelsüblichen Kupferbad.

### Beispiel 8

Analog Beispiel 7 erfolgt die Aktivierung durch Plasma mit Formiergas (N₂, H₂ (1:1)). Allerdings wird dann die Bekeimung mit einer Lösung von 200mg η²-Bipyridyl 4,4'-Dicarboxy-η²stilbenopalladium(II) in 500 ml Isopropanol, der 0,5 ml wässriger Ammoniak (24 %) zugesetzt wurde, durchgeführt.

### Beispiel 9

Analog Beispiel 7 erfolgt die Aktivierung durch ein Plasma mit Ammoniak. Allerdings wird dann die Bekeimung mit einer Lösung von 200 mg η²-Bipyridyl 4,4'-Dicarboxy-η²-stilbenopalladium(II) in 500 ml Isopropanol, der 0,5 ml wässriger Ammoniak (24 %) zugesetzt wurde, durchgeführt.

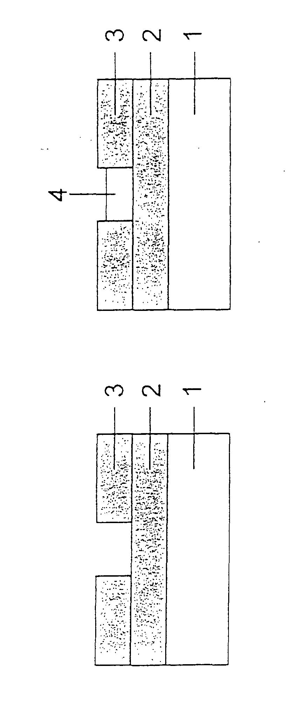

Die Figur zeigt einen Ausschnitt aus einem Bauelement wie einem Wafer, wobei im Querschnitt 4 Schichten zu erkennen sind: Unten das Substrat 1, auf dem die Isolierschicht 2, die aktiviert ist, anschließt. Die Isolierschicht 3 ist strukturiert und legt dadurch teilweise die Oberfläche der aktivierten Schicht 2 frei. An der freigelegten Oberfläche ist die Isolierschicht 2 durch Bekeimung und Metallisierung mit dem metallischen Leiterband 4 belegt.

Die Erfindung ermöglicht eine kostengünstige, selektive Metallisierung einer Isolierschicht ohne Strippen oder Rückätzung. Das Anwendungsspektrum des Verfahrens ist breit gefächert, weil keine Einschränkung hinsichtlich des eingesetzten Isolators besteht. Zudem können verschiedenste Isolatoren kombiniert werden. Bei der Nutzung von photosensitiven Materialien sind die Belichtungsenergien und bei der Nutzung von nicht photosensitivem Material sind die Druckzeiten gering, so dass ein guter Durchsatz erzielt wird. Das Verfahren ist kompatibel mit vorhandenen Prozeßlinien, weil bei der Verwendung von photosensitiven Isolatoren die Belichtung zur Aktivierung im nahen oder tiefen UV-Bereich erfolgen kann (200 bis 450 nm, insbesondere der Bereich von 350 bis 450 nm) und somit bereits in der Prozeßlinie existierende Belichtungsgeräte kostengünstig verwendet werden können. Das Polymer des Isolators wird durch die Aktivierung nicht abgebaut und/oder gespalten, so dass keine niedermolekularen Abfallprodukte entstehen.

Die Erfindung betrifft ein Verfahren zur Metallisierung eines Isolators und/oder Dielektrikums, wobei der Isolator zunächst aktiviert, anschließend mit einem weiteren Isolator beschichtet und dieser strukturiert, dann der erste bekeimt und schließlich metallisiert wird.

## Patentansprüche

1. Verfahren zur Metallisierung zumindest einer Isolierschicht eines elektronischen oder mikroelektronischen Bauteils, deren Schichtdicke maximal 50 µm beträgt, wobei zunächst
- zumindest eine Isolierschicht auf das Substrat aufgebracht und durch Behandlung mit einem Aktivator aktiviert wird,
- dann eine weitere Isolierschicht aufgebracht und strukturiert wird und schließlich
- die erste Isolierschicht bekeimt und metallisiert wird.

2. Verfahren nach Anspruch 1, bei dem die beiden Isolierschichten aus dem gleichen Material sind.

3. Verfahren nach Anspruch 1 oder 2, bei dem die erste Isolierschicht vor der Aufbringung der zweiten Isolierschicht strukturiert wird.
